Europäisches Patentamt

European Patent Office

Office européen des brevets

(19)

(11) EP 0 586 285 B1

(12) **FASCICULE DE BREVET EUROPEEN**

(45) Date de publication et mention
de la délivrance du brevet:
**25.09.1996 Bulletin 1996/39**

(51) Int Cl.6: **H04B 10/24**, H01S 3/00,
H04B 10/28

(21) Numéro de dépôt: **93402089.2**

(22) Date de dépôt: **24.08.1993**

(54) **Tête optique d'émission-réception pour transmission de données par système optique, et circuit de commutation pour cette tête**

Optischer Sender-Empfänger für optische Datenübertragung und Schalteinrichtung

Emitting-receiving optical head for optical data transmission and switching circuit for the head

(84) Etats contractants désignés:
**DE GB NL**

(30) Priorité: **01.09.1992 FR 9210433**

(43) Date de publication de la demande:
**09.03.1994 Bulletin 1994/10**

(73) Titulaire: **THOMSON-CSF
MICROELECTRONIQUE
75008 Paris (FR)**

(72) Inventeurs:
• **Defrancq, Jean-Marc
F-92402 Courbevoie Cedex (FR)**
• **Barnabé, Florence
F-92402 Courbevoie Cedex (FR)**
• **Rouzier, Alain
F-92402 Courbevoie Cedex (FR)**

(74) Mandataire: **Guérin, Michel et al
THOMSON-CSF
SCPI
B.P. 329
50, rue Jean-Pierre Timbaud
92402 Courbevoie Cédex (FR)**

(56) Documents cités:
**EP-A- 0 330 190            FR-A- 2 662 883**

• ELECTRONICS LETTERS. vol. 21, no. 11 , 23 Mai
1985 , STEVENAGE GB pages 511 - 512 J.P. VAN
DER ZIEL '7.5 km bidirectional single-mode
optical-fibre link using dual-mode InGaAsP/InP
1.3 micrometer laser detectors'
• PATENT ABSTRACTS OF JAPAN vol. 10, no. 263
(E-435)(2319) 9 Septembre 1986 & JP-A-61 089
735 (NTT)

## Description

La présente invention concerne une tête optique d'émission-réception utilisée pour les transmissions de données ou les télécommunications par fibres ou systèmes optiques.

Cette tête optique, étudiée pour fonctionner avec une seule fibre optique assurant la transmission des signaux dans les deux sens (full duplex), n'utilise qu'un seul composant optoélectronique, qui est un laser semiconducteur assisté par un circuit de commutation qui appartient à l'invention. Un tel composant optoélectronique émetteur-recepteur, muni d'un circuit de commutation d'un autre type est divulgué dans EP-A-0 330 190.

On sait que les fibres optiques constituent un moyen très puissant et très rapide pour les échanges de données, en particulier parce que la vitesse de la lumière est plus élevée que la vitesse des électrons. Mais la technologie en optoélectronique n'est pas aussi expérimentée qu'en électronique, notamment dans le domaine de la commutation d'un faisceau lumineux.

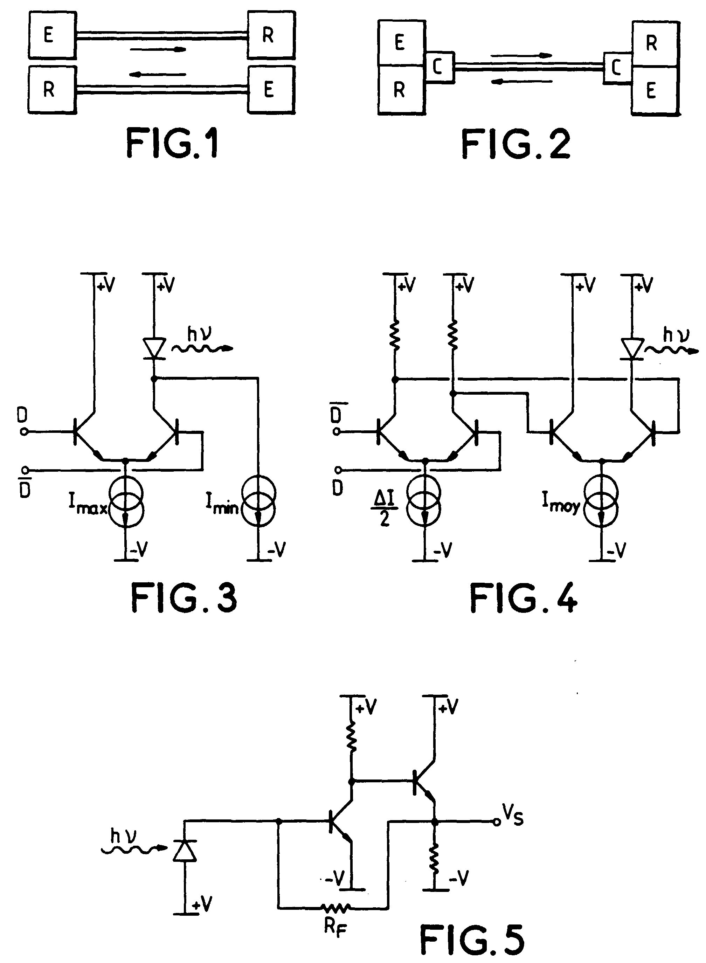

C'est ainsi que, pour transmettre des données, le schéma le plus simple, symbolisé en figure 1, consiste à exploiter deux fibres optiques, munies chacune, à leurs deux extrêmités, d'un semiconducteur E émetteur de lumière et d'un semiconducteur R récepteur de lumière, les deux circuits d'émission et de réception fonctionnant dans deux sens opposés.

On peut également n'utiliser qu'une seule fibre optique, comme cela est symbolisé sur la figure 2, mais il faut dans ce cas interposer entre la fibre optique et chacun de ses circuits d'embouts un démultiplexeur ou commutateur C : la plupart de ceux qui sont réellement utilisés sont basés sur des réflexions et sont plus proches de la construction mécanique que de la construction électronique.

Quel que soit le cas, parce qu'on ne sait pas bien commuter les faisceaux lumineux, on utilise deux types de composants différents pour l'émission et la réception, par terminal de la fibre optique, soit 4 puces de semiconducteurs.

Les circuits de commande de ces composants semiconducteurs sont assez simples et représentés en figures 3 à 5.

En émission, l'étage terminal de l'amplificateur d'émission - figure 3- est constitué d'habitude par une paire différentielle de transistors, pilotée par une source de courant $I_{max}$ et une source de courant $I_{min}$, qui sont connectées à une diode laser. Les données D et $\bar{D}$, s'il s'agit de transmission numérique, sont appliquées sur les bases des transistors et commandent $I_{max}$ qui traverse le laser, polarisé en direct.

Le montage de la figure 4 est équivalent à celui de la figure 3 : au lieu de contrôler directement $I_{max}$ et $I_{min}$ qui traversent le laser, on contrôle $I_{moy}$ dans la paire différentielle connectée au laser et on y additionne le courant d'excursion $\Delta I/2$ commandé par les données D et $\bar{D}$ appliquées sur une autre paire différentielle.

En réception, le photorécepteur, alimenté en inverse, est suivi par un amplificateur dont le montage connu le plus simple et le plus efficace est celui nommé transimpédance qui est représenté en figure 5. Le photorécepteur est de type diode photosensible.

L'invention apporte une grande simplification à la réalisation des liaisons de transmissions de données optiques, dans les systèmes numériques ou analogiques, en proposant une tête optique d'émission-réception ne mettant en oeuvre qu'un seul composant optoélectronique, une diode laser présentant de bonnes caractéristiques en émission (10 GHz) et en réception (3 GHz).

L'usage d'une diode laser comme photorécepteur est rendu possible par le circuit de commutation, objet de l'invention, qui permet d'isoler électriquement soit le circuit d'excitation pour l'émission, soit le circuit de détection, tout en conservant dans chaque cas un composant commun, qui est le laser polarisé en direct pour l'émission et en inverse pour la détection.

De façon plus précise, l'invention concerne une tête optique pour l'émission-réception, comportant un circuit optoélectronique aligné avec un système optique, cette tête optique étant caractérisée en ce qu'elle comporte un seul composant optoélectronique, qui est un laser semiconducteur, assisté par un circuit de commutation, qui assure une polarisation en inverse du laser pour la réception.

L'invention sera mieux comprise par la description qui suit d'un exemple d'application, faite en liaison avec les figures jointes en annexe qui représentent :

- figures 1 et 2 : Schémas généraux de liaisons optiques à 2 et à 1 fibre optique,
- figures 3 et 4 : Schémas électriques de polarisation d'un laser à l'émission, selon l'art connu,
- figure 5 : Schéma électrique de polarisation d'une photodiode en réception, selon l'art connu,
- figures 6 et 7 : Schémas du circuit de commutation selon l'invention, dans ses deux états.

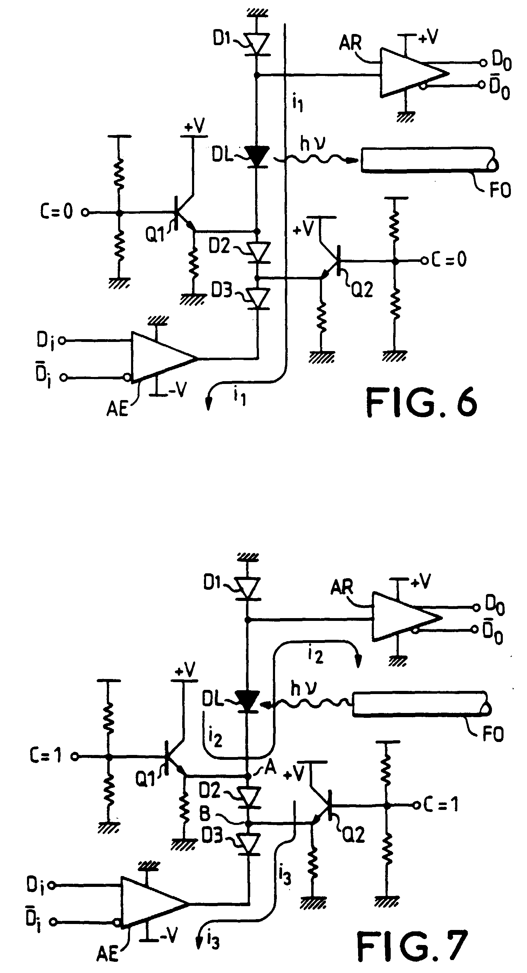

La tête optique selon l'invention n'ayant qu'un seul composant optoélectronique émetteur-récepteur, elle n'exige donc qu'une seule fibre optique pour la transmission des données, sans démultiplexeur comme dans l'art connu de la figure 2. Les figures 6 et 7 représentent le schéma électrique du circuit de commutation selon l'invention, dédoublé pour mieux en comprendre le fonctionnement en émission (figure 6) et en réception (figure 7). Toutefois, il est évident pour l'homme de l'art que l'exemple choisi pour illustrer l'invention peut être adapté à d'autres types de composants semiconducteurs (NPN, PNP, FETs...), ou à d'autres polarisations, et la fibre optique remplacée par un système optique atmosphérique, avec ou sans lentilles sans pour autant sortir du domaine de l'invention.

Ce circuit comporte essentiellement :

- 4 diodes montées en série entre une première et une deuxième source de tension, par exemple, la masse et une source d'alimentation négative -V, dans le sens passant. La seconde parmi ces 4 diodes est la diode laser DL
- un amplificateur d'émission AE dont la sortie est réunie à la cathode de la dernière diode D3
- un amplificateur de réception AR dont l'entrée est réunie à la cathode de la première diode D1,
- deux commandes C, alimentées à partir d'une troisième source de tension, constituées par deux transistors Q1 et Q2 dont les émetteurs sont réunis à l'anode de la deuxième diode D2 pour Q1 et à la cathode de la même D2 pour Q2. Les bases des transistors sont alimentées à travers des ponts diviseurs.

Pour les diodes D1,D2,D3, les diodes rapides de type Schottky confèrent deux avantages : leur constante de temps est faible, et le temps de commutation peut être inférieur à 250 ns, et de plus la chute de tension à leurs bornes est faible, ce qui modifie peu les circuits par rapport à une utilisation - sans ce circuit de commutation - classique, sans diodes Schottky.

Pour les deux entrées de commande C, les transistors Q1 et Q2 sont préférablement de type bipolaire NPN : leur faible capacité base collecteur et une fréquence de transition importante pour quelques milliampères permettent d'obtenir une bande passante d'environ 1 GHz.

Le schéma des figures 6 et 7 montre que les amplificateurs d'émission et de réception ont des entrées (AE) et des sorties (AR) adaptées aux données numériques. Leur équivalent adapté aux données analogiques, avec une seule entrée et une seule sortie, permettrait tout aussi bien d'exposer l'invention.

La figure 6 explique le fonctionnement en émission de la tête optique et du circuit de commutation. Les commandes C sont par exemple au zéro logique, c'est à dire que les transistors Q1 et Q2 sont bloqués, et n'interviennent pas dans le circuit de commutation. Si les transistors $Q_1$ et $Q_2$ sont des transistors à effet de champ normalement passant, les commandees C sont au contraire à "1 logique". Les diodes D1 à 3 et le laser DL sont polarisés en direct. L'amplificateur de réception AR a son entrée bloquée à environ -0,7 V, qui correspond à la chute de tension dans D1, et l'amplificateur AR est lui-même bloqué. La diode laser DL, en mode émission, est polarisée en direct entre -0,7 V (à la cathode de D1) et -3,1 V environ en sortie de l'amplificateur AE, et convertit en puissance optique émise vers la fibre optique F0 les données en courant i1 envoyées par l'amplificateur d'émission.

On observera qu'en émission l'amplificateur d'émission AE fonctionne tandis que l'amplificateur de réception AR est bloqué, par la polarisation de -0,7 V appliquée sur son entrée par D1, dont la seule présence sert à commuter l'amplificateur de réception AR.

Le fonctionnement en réception de la tête optique et du circuit de commutation est expliqué en figure 7, comparable à la figure 6 mais pour laquelle les courants sont différents.

Un signal optique, transporté par la fibre optique F0, est détecté par la diode laser DL si celle-ci est en mode réception, c'est à dire polarisée en inverse. Pour obtenir cette polarisation inverse, les commandes C sont polarisées à 1 logique et les transistors Q1 et Q2 sont conducteurs. Un courant $i_2$ traverse la diode laser DL en inverse, en allant de l'alimentation positive du transistor Q1 à la masse de l'amplificateur du réception AR, qui transmet donc sur ses sorties les informations parvenues par la fibre optique F0.

Le courant $i_2$ est contenu sur son parcours par la diode D1 qui est bloquée et par la diode D2 également bloquée. En effet, si on appelle A et B les deux points d'anode et cathode de la diode D2, points auxquels sont réunis les émetteurs des transistors Q1 et Q2, D2 est bloquée parce qu'on a choisi, au moyen de ponts diviseurs montés sur les bases des transistors Q1 et Q2, d'avoir une tension en B supérieure à la tension en A : D2 est polarisée en inverse.

Le choix des résistances des ponts diviseurs est guidé par la valeur de la tension en A, imposée pour diminuer la capacité équivalente du laser polarisé en inverse.

Durant les périodes de réception, l'amplificateur d'émission AE fonctionne : il est alimenté par un courant $i_3$ qui vient de l'alimentation positive du transistor Q2, traverse D3 et va à l'alimentation négative de l'amplificateur AE. Ce courant $i_3$ est isolé du courant $i_2$ par la diode D2, bloquée. Ainsi, en mode de réception, les deux amplificateurs sont en état de fonctionnement, mais les informations qui pourraient transiter par l'amplificateur AE sont bloquées par D2. Néanmoins, puisque AE fonctionne constamment, la tête optique passe plus vite d'un état d'émission à un état de réception, et réciproquement.

Le circuit de commutation a été exposé en utilisant des diodes D1 à D3 pour isoler différentes parties du circuit selon son utilisation pour l'émission ou la réception. Plusieurs variantes sont possibles qui appartiennent au domaine de l'invention, par exemple :

- les trois diodes D1 à D3 peuvent être remplacées par des transistors bipolaires montés en diodes, ce qui permet d'avoir une technologie homogène pour intégrer les amplificateurs et les transistors Q1, Q2 et D1 à D3
- la diode D1 peut être remplacée par un transistor à effet de champ. Cela nécessite évidemment une tension de grille $V_G$ qui n'était pas nécessaire avec une diode, mais cela permet de moduler sa résistance équivalente par rapport à la résistance d'entrée de l'amplificateur à transimpédance de réception
- les transistors de commandes Q1 et Q2 peuvent être remplacés par des portes logiques de type ET ou OU.

Bien entendu, la tête optique selon l'invention peut également émettre ou recevoir des données en électronique analogique : il suffit d'adapter les amplificateurs d'entrée et de sortie en offset, en gain etc ....

Ils n'ont plus besoin de deux entrées $D_i$ et $\overline{D}_i$ et de deux sorties $D_o$ et $\overline{D}_o$ : il leur suffit d'une voie référencée par rapport à une masse.

La tête optique selon l'invention est appliquée, de façon générale, dans le domaine des transmissions de données optiques, soit pour les télécommunications, soit pour l'instrumentation.

## Revendications

1. Circuit de commutation, pour l'assistance d'un laser semiconducteur (DL) fonctionnant en émission et en réception, caractérisé en ce qu'il comporte :

   - une première diode (D1), le laser (DL), une deuxième (D2) et une troisième (D3) diodes montées en série, dans le sens passant entre une première et une deuxième sources de tension.
   - un amplificateur d'émission (AE) dont la sortie est connectée à la cathode de la troisième diode (D3)
   - un amplificateur de réception (AR) dont l'entrée est connectée à la cathode de la première diode (D1)
   - deux moyens de commande du dit circuit (Q1,Q2), connectés le premier (Q1) à l'anode (A) de la deuxième diode (D2) et le second (Q2) à la cathode (B) de la même deuxième diode (D2), ces deux moyens de commande (Q1, Q2) étant alimentés par une troisième source de tension.

2. Circuit de commutation selon la revendication 1, caractérisé en ce que, en mode émission lumineuse, les moyens de commande (Q1,Q2) sont bloqués et le laser (DL) est polarisé en direct, un premier courant (i1) traversant les diodes (D1 à 3 + DL) depuis la première vers la deuxième source de tension, à l'amplificateur d'émission (AE).

3. Circuit de commutation selon la revendication 1, caractérisé en ce que, en mode réception lumineuse, les moyens de commande (Q1,Q2) sont rendus conducteurs, de telle façon que la tension sur la cathode de la deuxième diode (D2) est supérieure à la tension sur l'anode de la même diode (D2) qui est ainsi bloquée, et le laser (DL) est polarisé en inverse, un second courant (i2) traversant le premier moyen de commande (Q1), la diode laser (DL) et l'amplificateur de réception (AR), ce dit courant (i2) étant isolé du reste du circuit par la première (D1) et la deuxième (D2) diodes, bloquées.

4. Circuit de commutation selon la revendication 3, caractérisé en ce que, en mode réception, l'amplificateur d'émission (AE) fonctionne mais est isolé du laser (DL) par la deuxième diode (D2) bloquée.

5. Circuit de commutation selon la revendication 1, caractérisé en ce que les moyens de commandes (Q1,Q2) sont des transistors bipolaires.

6. Circuit de commutation selon la revendication 1, caractérisé en ce que les moyens de commandes (Q1,Q2) sont des portes logiques.

7. Circuit de commutation selon la revendication 1, caractérisé en ce que les diodes (D1 à 3) sont des transistors montés en diodes, de types bipolaires ou à effet de champ.

## Patentansprüche

1. Umschalt-Schaltung für die Unterstützung eines Halbleiterlasers (DL), der im Sende- und Empfangsbetrieb arbeitet, dadurch gekennzeichnet, daß sie enthält:

   - eine erste Diode (D1), den Laser (DL), eine zweite (D2) und eine dritte (D3) Diode, die zwischen einer ersten und einer zweiten Spannungsquelle in Durchlaßrichtung in Serie geschaltet sind,
   - einen Sendeverstärker (AE), dessen Ausgang an die Katode der dritten Diode (D3) angeschlossen ist,
   - einen Empfangsverstärker (AR), dessen Eingang an die Katode der ersten Diode (D1) angeschlossen ist,
   - zwei Steuermittel (Q1, Q2), wovon das erste an die Anode (A) der zweiten Diode (D2) und das zweite (Q2) an die Katode (B) dieser zweiten Diode (D2) angeschlossen ist, wobei diese zwei Steuermittel (Q1, Q2) durch eine dritte Spannungsquelle versorgt werden.

2. Umschalt-Schaltung nach Anspruch 1, dadurch gekennzeichnet, daß die Steuermittel (Q1, Q2) im Lichtsendemodus gesperrt sind und der Laser (DL) in Durchlaßrichtung vorgespannt ist, wobei ein erster Strom (i1) von der ersten zur zweiten Spannungsquelle durch die Dioden (D1 bis 3 und DL) zum Sendeverstärker (AE) fließt.

3. Umschalt-Schaltung nach Anspruch 1, dadurch gekennzeichnet, daß die Steuermittel (Q1, Q2) im Lichtempfangsmodus in der Weise leitend gemacht werden, daß die Spannung an der Katode der zweiten Diode (D2) größer als die Spannung an der Anode derselben Diode (D2) ist, welche somit gesperrt ist, und der Laser (DL) in Sperrrichtung vorgespannt ist, wobei ein zweiter Strom (i2) durch das erste Steuermittel (Q1), die Laserdiode (DL) und den Empfangsverstärker (AR) fließt, wobei dieser Strom (i2) von der restlichen Schaltung durch die erste (D1) und die zweite (D2) Diode, die beide gesperrt sind, getrennt ist.

4. Umschalt-Schaltung nach Anspruch 3, dadurch gekennzeichnet, daß der Sendeverstärker (AE) im Empfangsmodus arbeitet, jedoch vom Laser (DL) durch die zweite, gesperrte Diode (D2) getrennt ist.

5. Umschalt-Schaltung nach Anspruch 1, dadurch gekennzeichnet, daß die Steuermittel (Q1, Q2) Bipolartransistoren sind.

6. Umschalt-Schaltung nach Anspruch 1, dadurch gekennzeichnet, daß die Steuermittel (Q1, Q2) Logikgatter sind.

7. Umschalt-Schaltung nach Anspruch 1, dadurch gekennzeichnet, daß die Dioden (D1 bis 3) als Dioden geschaltete Transistoren des Bipolartyps oder des Feldeffekttyps sind.

**Claims**

1. Switching circuit, for the assistance of a semiconductor laser (DL) operating in emission mode and in reception mode, characterized in that it includes:

   - a first diode (D1), the laser (DL), a second (D2) and a third (D3) diode, which are mounted in series, in the forward-biased direction between a first and a second voltage source
   - an emission amplifier (AE) whose output is connected to the cathode of the third diode (D3)
   - a reception amplifier (AR) whose input is connected to the cathode of the first diode (D1)
   - two control means (Q1, Q3), the first (Q1) of which is connected to the anode (A) of the second diode (D2), and the second (Q2) of which is connected to the cathode (B) of the same second diode (D2), these two control means (Q1, Q2) being supplied by a third voltage source.

2. Switching circuit according to Claim 1, characterized in that, in light emission mode, the control means (Q1, Q2) are turned off and the laser (DL) is forward-biased, a first current (i1) flowing through the diodes (D1 to 3 + DL) from the first towards the second voltage source, to the emission amplifier (AE).

3. Switching circuit according to Claim 1, characterized in that, in light reception mode, the control means (Q1, Q2) are turned on, so that the voltage at the cathode of the second diode (D2) is greater than the voltage at the anode of the same diode (D2), which is thus turned off, and the laser (DL) is reverse-biased, a second current (i2) flowing through the first control means (Q1), the laser diode (DL) and the reception amplifier (AR), this said current (i2) being isolated from the rest of the circuit by the first diode (D1) and the second (D2) diode which are turned off.

4. Switching circuit according to Claim 3, characterized in that, in reception mode, the emission amplifier (AE) operates but is isolated from the laser (DL) by the second diode (D2) which is turned off.

5. Switching circuit according to Claim 1, characterized in that the control means (Q1, Q2) are bipolar transistors.

6. Switching circuit according to Claim 1, characterized in that the control means (Q1, Q2) are logic gates.

7. Switching circuit according to Claim 1, characterized in that the diodes (D1 to 3) are transistors, of bipolar or field-effect types, connected as diodes.

FIG.1

FIG.2

FIG.3

FIG.4

FIG.5

FIG. 6

FIG. 7